# EUROPEAN PATENT APPLICATION

(11) **EP 4 357 504 A1**
(43) Date of publication of application: **24.04.2024**
(21) Application number: 23204528.6
(22) Date of filing: 19.10.2023
(51) Int. Cl.: D04H 1/4374, B01D 69/12, B01D 71/64, B32B 5/02, B32B 27/28, D04H 1/56, H05K 1/03, D03D 1/00

(54) **HOMOGENEOUS COMPOSITE SUBSTRATE**

(30) Priority: 20.10.2022 TW 111139825
(71) Applicant: TAIWAN TEXTILE RESEARCH INSTITUTE, New Taipei City (TW)
(72) Inventor: CHOU, Shang-Chih, New Taipei City (TW); LIAO, Yuan-Pei, New Taipei City (TW); LIN, Yung-Tan, New Taipei City (TW)
(74) Representative: Winter, Brandl - Partnerschaft mbB

(57) **Abstract**

A homogeneous composite substrate includes a woven cloth and at least one fiber membrane. The woven cloth includes a plurality of first fibers. The fiber membrane is disposed on at least one surface of the woven cloth, and the fiber membrane includes a plurality of second fibers, in which a material of the first fibers and a material of the second fibers are the same, a fiber diameter of each first fiber is larger than or equal to 20 µm and smaller than or equal to 130 µm, and a fiber diameter of each second fiber is larger than or equal to 3 µm and smaller than or equal to 10 µm.

## Description

### BACKGROUND

### Field of Disclosure

The present disclosure relates to a composite substrate, and particularly relates to a homogeneous composite substrate.

### Description of Related Art

In the field of circuit substrates, a heterogeneous composite material is often used as the main material of the substrate. However, the heterogeneous composite material is prone to the problem of recycling. For example, a substrate made of carbon fiber and thermosetting epoxy resin needs to undergo a high-temperature and high-humidity process for the recycling of carbon fiber, leading difficulties in separating the materials. In addition, when the traditional wet papermaking process is used to prepare the substrate, it is easy to cause excessive consumption of water resources and waste of energy. On the other hand, when using a homogeneous composite material as the main material of the substrate, it is necessary to select the same materials with different melting points to combine the materials (e.g., combine high melting point polypropylene and low melting point polypropylene); however, the same materials with different melting points are difficult to be separated from each other. Therefore, how to provide a homogeneous composite material that can be applied in the field of circuit substrates is an important issue that is actively studied by those skilled in the art.

### SUMMARY

According to some embodiments of the present disclosure, a homogeneous composite substrate includes a woven cloth and at least one fiber membrane. The woven cloth includes a plurality of first fibers. The fiber membrane is disposed on at least one surface of the woven cloth, and the fiber membrane includes a plurality of second fibers, in which a material of the first fibers and a material of the second fibers are the same, a fiber diameter of each first fiber is larger than or equal to 20 µm and smaller than or equal to 130 µm, and a fiber diameter of each second fiber is larger than or equal to 3 µm and smaller than or equal to 10 µm.

In some embodiments of the present disclosure, the material of the first fibers and the material of the second fibers are polyetherimide.

In some embodiments of the present disclosure, the second fibers are melt-blown fibers.

In some embodiments of the present disclosure, a number of the at least one fiber membrane is two, and the two fiber membranes are disposed on two opposite surfaces of the woven cloth.

In some embodiments of the present disclosure, the two fiber membranes are in contact with each other between the first fibers.

In some embodiments of the present disclosure, a thermal processing temperature of the homogeneous composite substrate is larger than or equal to 200°C and smaller than or equal to 240°C.

In some embodiments of the present disclosure, a warp density of the woven cloth is larger than or equal to 70 threads/inch and smaller than or equal to 110 threads/inch, and a weft density of the woven cloth is larger than or equal to 53 threads/inch and smaller than or equal to 70 threads/inch.

In some embodiments of the present disclosure, a fiber strength of the first fibers is larger than or equal to 1.5 cN/dtex and smaller than or equal to 3.5 cN/dtex.

In some embodiments of the present disclosure, when the homogeneous composite substrate is tested under the standard specification ASTM D150, a dielectric constant of the homogeneous composite substrate is larger than or equal to 1.5 and smaller than or equal to 2.1, and a dielectric loss of the homogeneous composite substrate is larger than or equal to 0.0030 and smaller than or equal to 0.0074.

In some embodiments of the present disclosure, when the homogeneous composite substrate is tested under the standard specification ASTM D 638, a strength of the homogeneous composite substrate is larger than or equal to 13 MPa and smaller than or equal to 45 MPa.

According to the aforementioned embodiments of the present disclosure, through the design of the fiber diameters of the woven cloth and the fiber membrane in the homogeneous composite substrate of the present disclosure, the homogeneous composite substrate has advantages in the manufacturing process, and in combination with the structural design of the woven cloth and the fiber membrane, the homogeneous composite substrate can be provided with high structural strength. In addition, since the homogeneous composite substrate is a single material composite substrate, it can be recycled through the granulation process without separation, thereby achieving circular economy and high environmental protection. Furthermore, the homogeneous composite substrate does not need to be prepared through traditional wet papermaking process, thereby avoiding a large amount of water consumption and saving energy.

### BRIEF DESCRIPTION OF THE DRAWINGS

Fig. 1 is a schematic top view illustrating a homogeneous composite substrate according to some embodiments of the present disclosure;
Fig. 2 is a schematic top view illustrating a homogeneous composite substrate according to some other embodiments of the present disclosure; and
Fig. 3 is a schematic side view illustrating the homogeneous composite substrate shown in Fig. 2.

### DETAILED DESCRIPTION

The present disclosure provides a homogeneous composite substrate which includes cloths and membranes having the same material but different structures. That is, the homogeneous composite substrate of the present disclosure has a single material, and is also referred to as a single material composite substrate. Through the design of the fiber diameters of the cloths and the membranes in the homogeneous composite substrate, the homogeneous composite substrate has advantages in the manufacturing process, and in combination with the structural design of the cloths and the membranes, the homogeneous composite substrate can be provided with high structural strength. In addition, since the homogeneous composite substrate is a single material composite substrate, it can be recycled through the granulation process without separation, thereby achieving circular economy and high environmental protection. Furthermore, the homogeneous composite substrate does not need to be prepared through traditional wet papermaking process, thereby avoiding a large amount of water consumption and saving energy.

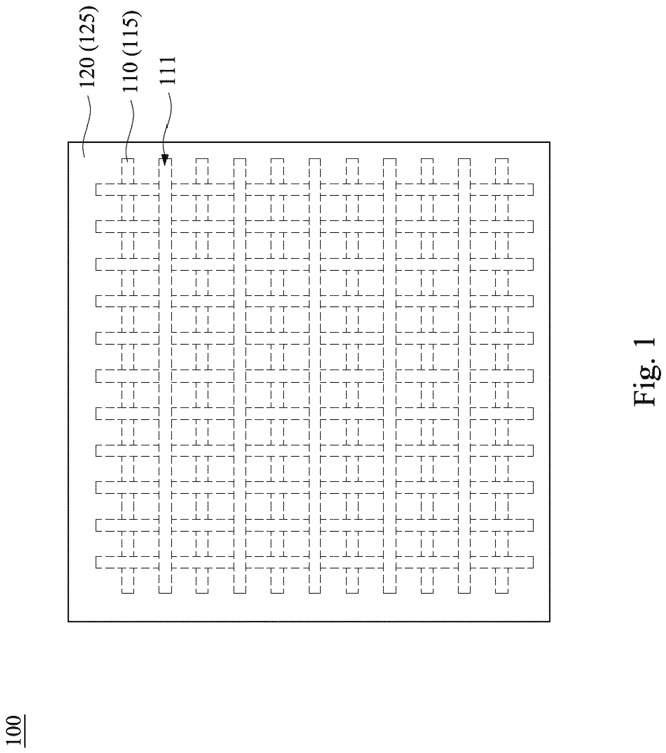

Reference is made to Fig. 1, which is a schematic top view illustrating a homogeneous composite substrate 100 according to some embodiments of the present disclosure. The homogeneous composite substrate 100 includes a woven cloth 110 and at least one fiber membrane 120, and the fiber membrane 120 is disposed on at least one surface 111 of the woven cloth 110. The woven cloth 110 includes a plurality of first fibers 115 interwoven with each other, the fiber membrane 120 includes a plurality of second fibers 125, and the material of the first fibers 115 is the same as the material of the second fibers 125. That is, the woven cloth 110 and the fiber membrane 120 are of the same material. In this way, the woven cloth 110 and the fiber membrane 120 do not need to be additionally combined with adhesive or coating, and the homogeneous composite substrate 100 of the present disclosure can be simply formed through a thermal pressing process. On the other hand, the woven cloth 110 and the fiber membrane 120 perform different functions in the homogeneous composite substrate 100. In detail, the woven cloth 110 is configured as a reinforcing material, such that the homogeneous composite substrate 100 has high structural strength, while the fiber membrane 120 is configured as a fixing material to fix and maintain the size and structural strength of the woven cloth 110, such that the homogeneous composite substrate 100 has high structural strength. The homogeneous composite substrate 100 can be applied in fields such as circuit insulating substrates.

In the homogeneous composite substrate 100 of the present disclosure, the fiber diameter of each first fiber 115 in the woven cloth 110 is larger than or equal to 20 µm and smaller than or equal to 130 µm, and the fiber diameter of each second fiber 125 in the fiber membrane 120 is larger than or equal to 3 µm and smaller than or equal to 10 µm. Through the design of the fiber diameter, the thermal processing temperature difference between the woven cloth 110 and the fiber membrane 120 during the thermal pressing process can be constructed, in which the thermal processing temperature difference can ensure that the woven cloth 110 does not melt during the thermal processing, thereby serving as a reinforcing material to provide high structural strength, and ensuring that the fiber membrane 120 partially melts during the thermal pressing process to serve as a fixing material, so as to firmly combine the fiber membrane 120 with the woven cloth 110 and help maintain the size of the woven cloth 110. Specifically, if the fiber diameter of the first fiber 115 is less than 20 µm and the fiber diameter of the second fiber 125 is greater than 10 µm, the thermal processing temperature of the woven cloth 110 and the thermal processing temperature of the fiber membrane 120 may be too close, such that the woven cloth 110 cannot be firmly combined with the fiber membrane 120 under the premise of maintaining the structural integrity of the woven cloth 110; if the fiber diameter of the first fiber 115 is greater than 130 µm, the woven cloth 110 may be too thick, which is not conducive to the lightness and thinness of the homogeneous composite substrate 100; and if the fiber diameter of the second fiber 125 is less than 3 µm, the thermal processing temperature of the fiber membrane 120 may be too low, thereby causing the whole piece of the fiber membrane 120 to be in a molten state during the thermal pressing process and lose its original shape. In some preferred embodiments, the fiber diameter of each second fiber 125 may be larger than or equal to 8 µm and smaller than or equal to 10 µm. Overall, through the design of the fiber diameters of the woven cloth 110 and the fiber membrane 120, the homogeneous composite substrate 100 has advantages in the manufacturing process.

In some embodiments, the thickness of the woven cloth 110 may be larger than or equal to 45 µm and smaller than or equal to 175 µm. In detail, the minimum thickness limit of the woven cloth 110 in the homogeneous composite substrate 100 prepared by the thermal pressing process is 45 µm; and if the thickness of the woven cloth 110 is greater than 175 µm, the overall thin structure of the homogeneous composite substrate 100 is easily affected. In some embodiments, the thickness of the fiber membrane 120 may be larger than or equal to 50 µm and smaller than or equal to 60 µm. In detail, if the thickness of the fiber membrane 120 is less than 50 µm, it may affect the fixing performance of the fiber membrane 120 on the woven cloth 110, thus further affect the performance of the high structural strength of the woven cloth 110; and if the thickness of the fiber membrane 120 is greater than 50 µm, the overall thin structure of the homogeneous composite substrate 100 is easily affected. In some preferred embodiments, the thickness of the woven cloth 110 may be larger than or equal to 50 µm and smaller than or equal to 100 µm, and the thickness of the fiber membrane 120 may be larger than or equal to 50 µm and smaller than or equal to 60 µm.

In some embodiments, the woven cloth 110 may be a woven fabric. Compared with the knitted fabric, the woven fabric may have higher structural strength. In some embodiments, the fiber strength of the first fibers 115 in the woven cloth 110 may be larger than or equal to 1.5 cN/dtex and smaller than or equal to 3.5 cN/dtex, such that the woven cloth 110 has a higher structural strength. In some embodiments, the warp density of the woven cloth 110 may be larger than or equal to 70 threads/inch and smaller than or equal to 110 threads/inch, and the weft density of the woven cloth 110 may be larger than or equal to 53 threads/inch and smaller than or equal to 70 threads/inch. In this way, the structure of the woven cloth 110 can be avoided from being too loose, thereby having sufficient structural strength. Overall, through the design of the fiber strength of the first fibers 115 in the woven cloth 110 and the design of the warp and weft density of the woven cloth 110, the structural strength of the woven cloth 110 can be maintained relatively high. In some embodiments, the first fibers 115 can be woven directly to form the woven cloth 110, or the first fibers 115 can be combined with each other to form a composite yarn (multi-filament) firstly, and then the composite yarns can be woven to form the woven cloth 110. That is, the one first fiber 115 shown in Fig. 1 can also be one composite yarn. For example, when the woven cloth 110 is woven from the composite yarns, the specification of one composite yarn may be larger than or equal to 84 dtex/24f and smaller than or equal to 88.1 dtex/24f. In some embodiments, the second fiber 125 in the fiber membrane 120 can be a melt-blown fiber. Since the melt-blown process can stably produce fibers with small fiber diameters, the melt-blown process is suitable for forming fibers with a fiber diameter larger than or equal to 3 µm and smaller than or equal to 10 µm, thereby having advantages and convenience in the manufacturing process.

In some embodiments, the material of the first fiber 115 in the woven cloth 110 and the material of the second fiber 125 in the fiber membrane 120 are polyetherimide (PEI). Using polyetherimide as the material of the first fibers 115 and the second fibers 125 is beneficial to form the homogeneous composite substrate 100 of the present disclosure with high structural strength. In detail, since polyetherimide is a non-crystalline material that can be shaped by heating but has no actual melting point, the thermal processing temperature of polyetherimide can vary with the size of the material (polyetherimide), and therefore the present disclosure can construct the thermal processing temperature difference between the woven cloth 110 and the fiber membrane 120 during the thermal pressing process through the fiber diameter (size) design of the first fiber 115 and the second fiber 125. In addition, since polyetherimide has good heat resistance and high mechanical strength that are provided by the imide group and good formability that is provided by the ether group, polyetherimide can have high heat resistance and high stability. On the other hand, since polyetherimide can meet the requirements of flame retardant (F), low smoke (S), and low toxicity (T), (i.e., polyetherimide has excellent "FST" characteristics), polyetherimide can have high transmission characteristics and low dielectric loss. As such, the homogeneous composite substrate 100 of the present disclosure is suitable for being applied in components that require the function of electrical insulation, such as electronic/electrical insulating paper, printed circuit insulating substrates, etc.

As mentioned above, the present disclosure can combine the woven cloth 110 and the fiber membrane 120 to form a homogeneous composite substrate 100 through a thermal pressing process. Since the thermal pressing process is a dry process, which does not require the use of liquid such as water and organic solvent that cause waste liquid problems, the homogeneous composite substrate 100 is environmentally friendly. In some embodiments, the processing temperature of the homogeneous composite substrate 100 during the thermal pressing process (also referred to as the thermal processing temperature) may be larger than or equal to 200°C and smaller than or equal to 240°C. Since the above-mentioned thermal processing temperature range has nearly reached the thermal processing temperature of the fiber membrane 120, but has not yet reached the thermal processing temperature of the woven cloth 110, it can be ensured that the fiber membrane 120 is in a partially molten state (e.g., the surface of the fiber membrane 120 that is in contact with the woven cloth 110 is in a molten state) and that the structure of the woven cloth 110 is not damaged and still has high structural strength. In this way, the woven cloth 110 and the fiber membrane 120 can be tightly and firmly combined, in which the integrity of the woven cloth 110 can be maintained, such that the woven cloth 110 can act as a reinforcing material, thereby providing a high structural strength of the homogeneous composite substrate 100, while the fiber membrane 120 can moderately melt, such that the fiber membrane 120 can act as a fixing material. In addition, the fiber membrane 120 can further maintain its originally complete shape, thereby assisting in maintaining (fixing) the size of the woven cloth 110. In some embodiments, the pressure of the thermal pressing process may be larger than or equal to 40 kgf and smaller than or equal to 60 kgf, and the time of the thermal pressing process may be larger than or equal to 20 seconds and smaller than or equal to 40 seconds.

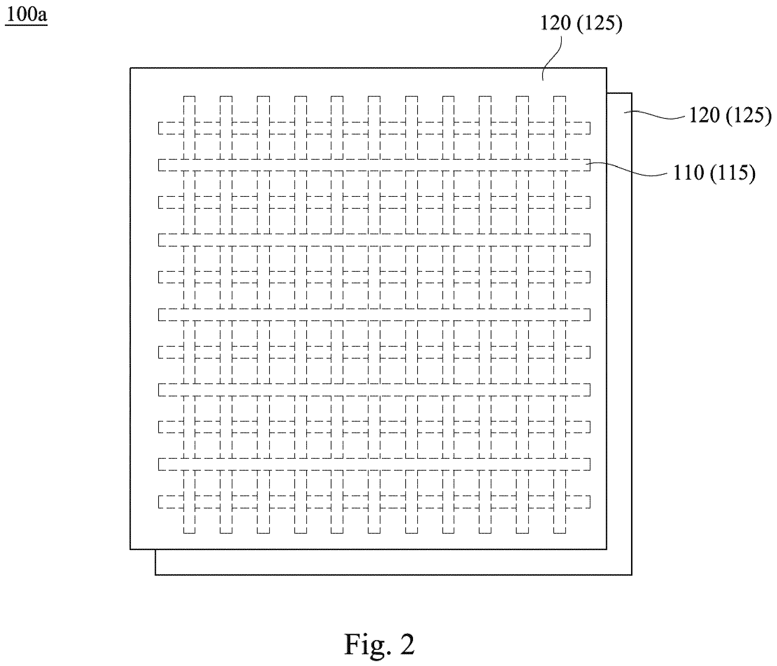

Reference is made to Fig. 2, which is a schematic top view illustrating a homogeneous composite substrate 100a according to some other embodiments of the present disclosure. At least one difference between the homogeneous composite substrate 100a in Fig. 2 and the homogeneous composite substrate 100 in Fig. 1 is that the homogeneous composite substrate 100a in Fig. 2 has two fiber membranes 120, and the two fiber membranes 120 are disposed on opposite surfaces (surfaces 111, 113) of the woven cloth 110. In other words, in the embodiment shown in Fig. 2, the woven cloth 110 is sandwiched between the two fiber membranes 120. In this way, the woven cloth 110 can be protected by the fiber membranes 120 from being exposed to the external environment, and the size and shape of the woven cloth 110 can be better fixed by the configuration of the fiber membranes 120. As such, it is beneficial for the woven cloth 110 to realize its high structural strength performance (i.e., to realize the function of a reinforcing material), and it is also beneficial for the fiber membrane 120 to realize its fixing performance (i.e., to realize the function of a fixing material). Therefore, during the use of the homogeneous composite substrate 100a, the loss of the structural strength of the woven cloth 110 can be slowed down, such that the homogeneous composite substrate 100a has a wider application and a longer lifespan.

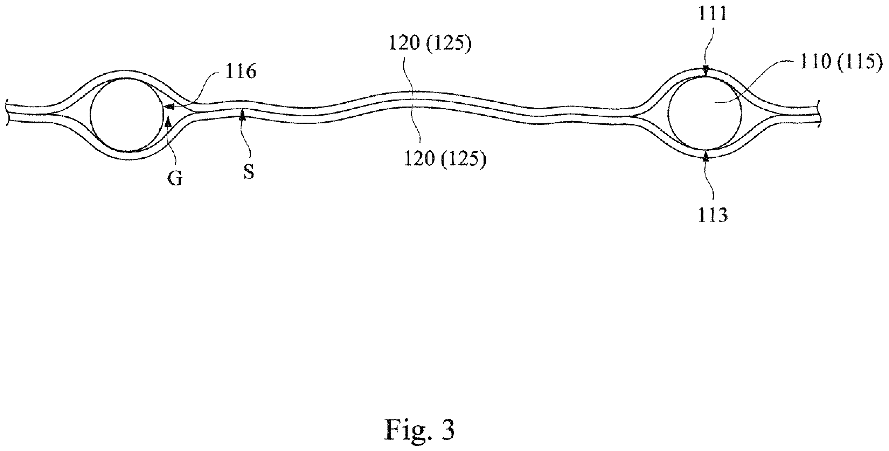

In some embodiments, the two fiber membranes 120 in the homogeneous composite substrate 100a may be in contact with each other between the first fibers 115 of the woven cloth 110. Specifically, Reference is made to Fig. 3, which is a schematic side view illustrating the homogeneous composite substrate 100a shown in Fig. 2. As shown in Fig. 3, the two fiber membranes 120 can be partially melted between the first fibers 115 to combine with each other by the thermal pressing process. That is, the first fibers 115 can be surrounded by the fiber membranes 120 to be fixed. Accordingly, the woven cloth 110 can better maintain its structure and provide higher structural strength, and the homogeneous composite substrate 100a is less prone to unexpected deformation. It is worth noting that since the material of the two fiber membranes 120 are the same, there may not be a substantial interface at the contact surface S of the two fiber membranes 120, and since the thermal processing temperature of the thermal pressing process has not reached the thermal processing temperature of the woven cloth 110, the surface 116 of the first fiber 115 in the woven cloth 110 can still maintain its original state without deformation due to thermal pressing. On the other hand, there may be a gap G between the fiber membrane 120 and the surface 116 of the first fiber 115 that faces the contact surface S. That is, the surface 116 of a single first fiber 115 may only be partially in contact with the fiber membrane 120.

The features and efficacy of the present disclosure will be described in more detail below with reference to various comparative examples and various embodiments. It should be understood that the materials used, their amounts and proportions, processing details, and processing procedures may be appropriately changed without departing from the scope of the present disclosure. Therefore, the present disclosure should not be limited by the embodiments described below.

The details of the substrate of Comparative Example 1, the parameters of the thermal pressing process used to prepare the homogeneous composite substrate of each embodiment, and the details of the homogeneous composite substrate of each embodiment are shown in Table 1. It should be understood that the structure of the homogeneous composite substrate in each embodiment is the structure shown in Fig. 2.

**Table 1**

| Embodiment/ Comparative Example | | Details of Fiber Membrane | | Total Thickness of Homogeneous Composite Substrate (µm) | Parameters of Thermal Pressing Process | | |
|---|---|---|---|---|---|---|---|
| | Details of Woven Cloth | Thickness (µm) | Second Fiber Diameter (µm) | | Processing Temperature (°C) | Pressure (kgf) | Time (s) |
| Embodiment 1 | [First Fiber] Single Fiber | 50 | 10 | 400 | 220 | 40 | 40 |
| | [First Fiber Diameter] 120 µm | | | | | | |
| Embodiment 2 | [First Fiber] Multi-Filament | 50 | 10 | 150 | 220 | 60 | 40 |
| Embodiment 3 | [Multi-filament specifications] 88.1 dtex/24f | 60 | 10 | 150 | 220 | 50 | 40 |
| Embodiment 4 | [Warp Density] 70 threads /inch | 60 | 10 | 150 | 220 | 50 | 40 |
| Embodiment 5 | [Weft Density] | 60 | 10 | 150 | 220 | 50 | 60 |
| Embodiment 6 | 53 threads /inch | 60 | 10 | 140 | 220 | 60 | 40 |
| Embodiment 7 | | 60 | 10 | 140 | 220 | 60 | 20-40 |
| Embodiment 8 | | 50 | 8 | 150 | 220 | 50 | 60 |
| Embodiment 9 | | 50 | 8 | 140 | 220 | 60 | 40 |
| Embodiment 10 | [First Fiber] Multi-Filament | 60 | 8 | 170 | 220 | 50 | 60 |
| | [Multi-filament specifications] 84 dtex/24f | | | | | | |
| Embodiment 11 | [Warp Density] 110 threads /inch | 60 | 8 | 170 | 220 | 50 | 60 |
| Embodiment 12 | [Weft Density] 70 threads /inch | 50 | 8 | 1140 | 220 | 50 | 60 |
| Comparative Example 1 | N/A | 50 | 8 | 50 | N/A | | |

### <Experiment 1: Strength Test on Substrate>

In this experiment, the standard specification ASTM D 638 was carried out to perform the strength test on the substrate of Comparative Example 1 and the homogeneous composite substrate of each embodiment. The results are as shown in Table 2.

**Table 2**

| Embodiment/ Comparative Example | Strength (MPa) | Elongation (%) |
|---|---|---|
| Embodiment 1 | 16.4 ± 1.5 | 58.9 ± 4.3 |
| Embodiment 2 | 16.9 ± 0.8 | 74.1 ± 3.8 |
| Embodiment 3 | 15.5 ± 1.3 | 4.7 ± 0.3 |
| Embodiment 4 | 15.1 ± 0.7 | 3.5 ± 0.4 |
| Embodiment 5 | 14.7 ± 0.4 | 4.7 ± 0.5 |
| Embodiment 6 | 19.7 ± 2.1 | 5.8 ± 1.1 |
| Embodiment 7 | 18.8 ± 0.6 | 5.0 ± 0.6 |
| Embodiment 8 | 13.9 ± 0.3 | 3.9 ± 0.2 |
| Embodiment 9 | 14.4 ± 0.9 | 8.0 ± 1.8 |
| Embodiment 10 | 41.1 ± 1.8 | 9.9 ± 3.3 |
| Embodiment 11 | 40.0 ± 4.8 | 10.2 ± 2.7 |
| Embodiment 12 | 35.0 ± 1.8 | 12.4 ± 2.0 |
| Comparative Example 1 | 6.4 ± 0.1 | 12.8 ± 2.5 |

It can be seen from Table 2 that the strength of the homogeneous composite substrate of each embodiment is significantly greater than the strength of the substrate of Comparative Example 1, and the strength of the homogeneous composite substrate is larger than or equal to 13 MPa and smaller than or equal to 45 MPa. It should be understood that the strength of the homogeneous composite substrate of the present disclosure can be between any two strength values in Table 2 from the test results of other embodiments which are not listed.

### <Experiment 2: Dielectric Properties Test on Substrate>

In this experiment, the standard specification ASTM D150 was carried out to perform the dielectric properties test on the homogeneous composite substrate of each embodiment. The results are shown in Table 3.

**Table 3**

| Embodiment | Dielectric Constant | Dielectric Loss |
|---|---|---|
| | 10 GHz | |
| Embodiment 1 | 1.5 | 0.0030 |
| Embodiment 2 | 1.5 | 0.0030 |
| Embodiment 3 | 2.1 | 0.0066 |
| Embodiment 4 | 2.1 | 0.0066 |
| Embodiment 5 | 2.0 | 0.0074 |
| Embodiment 6 | 1.8 | 0.0059 |
| Embodiment 7 | 1.8 | 0.0059 |
| Embodiment 8 | 1.8 | 0.0055 |
| Embodiment 9 | 1.8 | 0.0055 |
| Embodiment 10 | 2.0 | 0.0050 |
| Embodiment 11 | 2.0 | 0.0061 |
| Embodiment 12 | 1.8 | 0.0045 |

It can be seen from Table 3 that since the dielectric constant of the homogeneous composite substrate of each embodiment is larger than or equal to 1.5 and smaller than or equal to 2.1, and the dielectric loss of the homogeneous composite substrate of each embodiment is larger than or equal to 0.0030 and smaller than or equal to 0.0074, and since the homogeneous composite substrate of each embodiment has a thin structure, the homogeneous composite substrate of the present disclosure is suitable for being applied in electronic/electrical insulating paper, printed circuit insulating substrates, and other components that require the function of electrical insulation. It should be understood that, from the test results of other embodiments which are not listed, the dielectric constant of the homogeneous composite substrate of the present disclosure can be between any two dielectric constant values in Table 3, and the dielectric loss of the homogeneous composite substrate of the present disclosure can be between any two dielectric loss values in Table 3.

### <Experiment 3: Smoke Density Test and Smoke Toxicity Index Test on Substrate>

In this experiment, the standard specification ASTM E 662 was carried out to perform the smoke density test on the substrate of Comparative Example 2 and the homogeneous composite substrate of Embodiment 10, and the standard specification ABD-0031 was carried out to perform the smoke toxicity index test on the substrate of Comparative Example 2 and the homogeneous composite substrate of Embodiment 10. The results are shown in Table 4, in the substrate of Comparative Example 2 is commercially available Nomex paper.

**Table 4**

| Embodiment/ Comparative Example | Smoke Density | Smoke Toxicity Index | | | | | |
|---|---|---|---|---|---|---|---|
| | | Hydrofluoric Acid | Hydrochloric Acid | Hydrogen Cyanide | Sulfur Oxides | Carbon Monoxides | Nitrogen Oxides |
| Embodiment 10 | 0.2 | not detected | not detected | not detected | <20 | 10 | <2 |
| Comparative Example 2 | 8.5 | not detected | not detected | 2 | <20 | 30 | 2 |

It can be seen from Table 4 that compared to the substrate of Comparative Example 2, the homogeneous composite substrate of Embodiment 10 obviously has a lower smoke density, and the homogeneous composite substrate of Embodiment 10 has a better performance in the smoke toxicity index, indicating that the homogeneous composite substrate of the present disclosure has excellent FST characteristics.

According to the aforementioned embodiments of the present disclosure, through the design of the fiber diameters of the woven cloth and the fiber membrane in the homogeneous composite substrate of the present disclosure, the homogeneous composite substrate has advantages in the manufacturing process, and in combination with the structural design of the woven cloth and the fiber membrane, the homogeneous composite substrate can be provided with high structural strength. In addition, since the homogeneous composite substrate is a single material composite substrate, it can be recycled through the granulation process without separation, thereby achieving circular economy and high environmental protection. Furthermore, the homogeneous composite substrate does not need to be prepared through traditional wet papermaking process, thereby avoiding a large amount of water consumption and saving energy. On the other hand, when polyetherimide is used as the material of the woven cloth and the fiber membrane, the homogeneous composite substrate can be further provided with high heat resistance and high stability.

## Claims

1. A homogeneous composite substrate (100), **characterized by** comprising:
a woven cloth (110) comprising a plurality of first fibers (115); and
at least one fiber membrane (120) disposed on at least one surface (111) of the woven cloth (110) and comprising a plurality of second fibers (125), wherein a material of the first fibers (115) and a material of the second fibers (125) are the same, a fiber diameter of each of the first fibers (115) is larger than or equal to 20 µm and smaller than or equal to 130 µm, and a fiber diameter of each of the second fibers (125) is larger than or equal to 3 µm and smaller than or equal to 10 µm.

2. The homogeneous composite substrate (100) of claim 1, **characterized in that** the material of the first fibers (115) and the material of the second fibers (125) are polyetherimide.

3. The homogeneous composite substrate (100) of anyone of claims 1 to 2, **characterized in that** the second fibers (125) are melt-blown fibers.

4. The homogeneous composite substrate (100) of anyone of claims 1 to 3, **characterized in that** a number of the at least one fiber membrane (120) is two, and the two fiber membranes (120) are disposed on two opposite surfaces (111, 113) of the woven cloth (110).

5. The homogeneous composite substrate (100) of claim 4, **characterized in that** the two fiber membranes (120) are in contact with each other between the first fibers (115).

6. The homogeneous composite substrate (100) of anyone of claims 1 to 5, **characterized in that** a thermal processing temperature of the homogeneous composite substrate (100) is larger than or equal to 200°C and smaller than or equal to 240°C.

7. The homogeneous composite substrate (100) of anyone of claims 1 to 6, **characterized in that** a warp density of the woven cloth (110) is larger than or equal to 70 threads/inch and smaller than or equal to 110 threads/inch, and a weft density of the woven cloth (110) is larger than or equal to 53 threads/inch and smaller than or equal to 70 threads/inch.

8. The homogeneous composite substrate (100) of anyone of claims 1 to 7, **characterized in that** a fiber strength of the first fibers (115) is larger than or equal to 1.5 cN/dtex and smaller than or equal to 3.5 cN/dtex.

9. The homogeneous composite substrate (100) of anyone of claims 1 to 8, **characterized in that** when the homogeneous composite substrate (100) is tested under the standard specification ASTM D150, a dielectric constant of the homogeneous composite substrate (100) is larger than or equal to 1.5 and smaller than or equal to 2.1, and a dielectric loss of the homogeneous composite substrate (100) is larger than or equal to 0.0030 and smaller than or equal to 0.0074.

10. The homogeneous composite substrate (100) of anyone of claims 1 to 9, **characterized in that** when the homogeneous composite substrate (100) is tested under the standard specification ASTM D 638, a strength of the homogeneous composite substrate (100) is larger than or equal to 13 MPa and smaller than or equal to 45 MPa.
